# EUROPEAN PATENT SPECIFICATION

(11) **EP 4 485 800 B1**
(45) Date of publication and mention of the grant of the patent: **10.09.2025**
(21) Application number: 24208861.5
(22) Date of filing: 07.08.2018
(51) Int. Cl.: H03K 3/84

(54) **RANDOM NUMBER GENERATOR**
ZUFALLSZAHLENGENERATOR
GÉNÉRATEUR DE NOMBRES ALÉATOIRES

(30) Priority: 17.05.2018 PL 42558518; 17.05.2018 PL 42558618
(43) Date of publication of application: 01.01.2025
(62) Divisional of application: 18918533.3
(73) Proprietor: POLITECHNIKA WARSZAWSKA, 00-661 Warszawa (PL)
(72) Inventor: GOLOFIT, Krzysztof, 02-796 Warszawa (PL); WIECZOREK, Piotr, 04-022 Warszawa (PL)
(74) Representative: Wroblewski, Marcin Jan

(56) References cited:
- WO-A1-2017/146650
- US-A1- 2014 250 160
- US-A1- 2015 154 006
- WIECZOREK PIOTR Z ET AL: "Influence of radiation on metastability-based TRNG", PROCEEDINGS OF SPIE; [PROCEEDINGS OF SPIE ISSN 0277-786X VOLUME 10524], SPIE, US, vol. 10445, 7 August 2017 (2017-08-07), pages 1044529 - 1044529, XP060091481, ISBN: 978-1-5106-1533-5, DOI: 10.1117/12.2280978
- WIECZOREK PIOTR ZBIGNIEW ET AL: "Dual-Metastability Time-Competitive True Random Number Generator", IEEE TRANSACTIONS ON CIRCUITS AND SYSTEMS I: REGULAR PAPERS, IEEE, US, vol. 61, no. 1, 1 January 2014 (2014-01-01), pages 134 - 145, XP011536840, ISSN: 1549-8328, [retrieved on 20140106], DOI: 10.1109/TCSI.2013.2265952
- WIECZOREK PIOTR ZBIGNIEW ET AL: "True Random Number Generator Based on Flip-Flop Resolve Time Instability Boosted by Random Chaotic Source", IEEE TRANSACTIONS ON CIRCUITS AND SYSTEMS I: REGULAR PAPERS, IEEE, US, vol. 65, no. 4, 1 April 2018 (2018-04-01), pages 1279 - 1292, XP011678918, ISSN: 1549-8328, [retrieved on 20180309], DOI: 10.1109/TCSI.2017.2751144
- WIECZOREK PIOTR Z ED - HEMMATI HAMID *1954-* [HERAUSGEBERIN] IDENTITY ET AL: "Secure TRNG with random phase stimulation", PROCEEDINGS OF SPIE; [PROCEEDINGS OF SPIE ISSN 0277-786X VOLUME 10524], SPIE, US, vol. 10445, 7 August 2017 (2017-08-07), pages 104452A - 104452A, XP060091482, ISBN: 978-1-5106-1533-5, DOI: 10.1117/12.2280979

## Description

### Technical field

The invention concerns a random number generator intended especially for generating truly random numbers and series.

### Background

There are known in the art designs of random number generators, which use pairs of ring oscillators and bistables, such as a phase detector or a metastability circuit.

In the state of the art, from the article by Piotr Z. Wieczorek, "Secure TRNG with Random Phase Stimulation", XL-th IEEE-SPIE Joint Symposium on Photonics, Web Engineering, Electronics for Astronomy and High Energy Physics Experiments, Wilga 2017, SPIE volume 10445, ISBN: 9781510613546, Electronic ISBN: 9781510613553, there is known a random number generator, which comprises two ring oscillators and a metastability circuit. Outputs of the ring oscillators are connected to inputs of the metastability circuit, whereas an output of the metastability circuit is an output of the random number generator. A ring oscillator comprise a delay line closed in a loop, where an input and an output are connected with each other and connected to an output of the ring oscillator. The delay line comprise delays connected in series and connected between the input and the output of the delay line. The disadvantage of such a random number generator is its low speed resulting from rare occurrences of events that are able to initiate a metastable work of the metastability circuit, which results from slow-moving random walk in phase.

From the publication of the US patent application US2011169580, there is known in the art a random number generator comprising two ring oscillators a phase detector. Outputs of two ring oscillators are connected to inputs of the phase detector, whereas an output of the phase detector is connected to an output of the random number generator through a von Neumann corrector. A ring oscillator comprise a delay line closed in a loop, where an input and an output are connected with each other and connected to an output of the ring oscillator. The delay line comprise delays connected in series and connected between the input and the output of the delay line.

From the article by Piotr Z. Wieczorek and Zbigniew Wieczorek "Influence of radiation on metastability-based TRNG", PROCEEDINGS OF SPIEISSN 0277-786X VOLUME 10524, SPIE, US, vol. 10445, 7 August 2017 (2017-08-07), pages 1044529-1044529, DOI: 10.1117/12.2280978, ISBN: 978-1-5106-1533-5, there is known a true random number generator based on flip-flops with violated timing constraints. The true random number generator circuit utilizes the metastability phenomenon as a source of randomness. The article further discloses that the metastable range of operation enhances the noise influence on a flip-flop behavior.

From the article by Piotr Z. Wieczorek and Krzysztof Golofit "Dual-Metastability Time-Competitive True Random Number Generator", IEEE TRANSACTIONS ON CIRCUITS AND SYSTEMS I: REGULAR PAPERS, IEEE, US, vol. 61, no. 1, 1 January 2014 (2014-01-01), pages 134-145, XP011536840, ISSN: 1549-8328, DOI: 10.1109/TCSI.2013.2265952, there is known hardware-based true random number generator that exploits the phenomenon of metastability in digital circuits. Traditional TRNGs that utilize metastability rely on bringing a digital element (like a flip-flop or latch) into a metastable state. However, precisely hitting the metastable point is nearly impossible in practice, and doing so doesn't guarantee sufficient entropy or randomness. In the article there is proposed a new method that compares the resolution times of two independently operating metastable elements, rather than depending on reaching a single metastable state. This approach avoids the need for precise control and enhances robustness.

From the publication of the US patent application US2015154006, there is known in the art a true random number generator comprising a ring oscillator, a control circuit configured to trigger the ring oscillator to start oscillating in a first mode of oscillation at an oscillation start time; and a time measuring circuit configured to measure a collapse time value indicative of a length of time from the oscillation start time to an oscillation collapse time at which the ring oscillator switches

The aim of the invention is to provide a random number generator of the construction causing that at least one additional bistable of said generator is triggered by the input signal with a different phase than the phase that is currently present in ring oscillators of said generator.

### Summary

A random number generator comprising a first bistable, having an output connected to a first output of the random number generator and comprising two ring oscillators, having outputs connected to inputs of the bistable, whereas the ring oscillators comprise delay lines closed in a loops, and the delay lines comprise delays connected in series between inputs and outputs of the delay lines, wherein the random number generator comprises at least one additional bistable, having output connected to an additional output of the random number generator, whereas the additional bistable has a first input connected to the delay line of one of the ring oscillators and a second input connected to the delay line of the other of the two ring oscillators, wherein at least one of the bistables is a metastability circuit, wherein at least one metastability circuit comprises a metastable generator of time intervals, having inputs connected to the inputs of the metastability circuit and outputs connected to inputs of an arbiter circuit, having outputs connected to the outputs of the metastability circuit through a logic circuit, wherein the metastable generator of time intervals comprises two flip-flops, each having two inputs and a single output, wherein one of the two inputs is a data input and the other of the two inputs is a clock input and wherein, the single output is a normal output, wherein the inputs of the flip-flops of the metastable generator of time intervals are connected to the inputs of the metastability circuit and wherein the first input of the metastability circuit is connected to the data input of the first flip-flop and the data input of the second flip-flop, and the second input of the metastability circuit is connected to the clock input of the first flip-flop and the clock input of the second flip-flop, wherein the arbiter circuit comprises two flip-flops, each having two inputs and two outputs, wherein one of the two inputs is a data input and the other of the two inputs is a clock input, and wherein one of the two outputs is a normal output and the other of the two outputs is a complementary output, and wherein the normal output of the first flip-flop of the metastable generator of time intervals is connected to the data input of the first flip-flop of the arbiter circuit and the clock input of the second flip-flop of the arbiter circuit, the normal output of the second flip-flop of the metastable generator of time intervals is connected to the clock input of the first flip-flop of the arbiter circuit and the data input of the second flip-flop of the arbiter circuit, and wherein the logic circuit consists of a conjunction gate, through which selected outputs of the flip-flops of the arbiter circuit are connected to the outputs of the metastability circuit, wherein the inputs of the logic circuit are connected to the complementary output of the first flip-flop of the arbiter circuit and the normal output of the second flip-flop of the arbiter circuit. The essence of the invention is that at least one of the additional bistables is connected with the first input to a series of delays of a delay line of one of the ring oscillators after a delay having the first number in this series counting from the beginning of the delay line, and the second input is connected to a series of delays of a delay line of another ring oscillator after a delay having the second number in this series counting from the beginning of the delay line, wherein the first number is different from the second number. Such a solution causes that the bistable is triggered by the input signal with a different phase than the phase that is currently present in the ring oscillators.

Random number generator according to the invention advantageously comprises at least one more ring oscillator. The effect is that the bistables connected to different ring oscillators are stimulated with less correlated signals than the bistables connected to the same ring oscillators. Advantageously, the additional bistable, having the output connected to the additional output of the random number generator, has the first input connected to the delay line of one of the ring oscillators and the second input connected to the delay line of the second or the third of the ring oscillators.

Random number generator according to the invention advantageously comprises at least two bistables, having at least one of the inputs connected to different delay lines of different ring oscillators. Such a solution assures that the bistables are stimulated with different pair of ring oscillators, and thus with different processes resulting in phase shifts.

At least two bistables advantageously are connected with at least one input each in the same place of at least one delay line. Having different bistables connected in the same places causes that the bistables are triggered with exactly the same signal.

At least one of the bistables advantageously is a phase detector. Phase detector provides a precise detection of the edge priority of input waveforms, which is used for phase correction.

At least one phase detector advantageously consists of a flip-flop with two inputs being the inputs of the phase detector and an output being the output of the phase detector.

Alternatively at least one phase detector comprises two flip-flops each having two inputs and two outputs, wherein the inputs of the flip-flops are connected to inputs of the phase detector, and outputs of the flip-flops are connected to outputs of the phase detector. Further the first input of the phase detector is connected to both the first input of the first flip-flop and the second input of the second flip-flop. Further the second input of the phase detector is connected to both the second input of the first flip-flop and the first input of the second flip-flop. Further the output of the phase detector is connected to chosen outputs of the flip-flops through a logic circuit.

At least one of the bistables advantageously is a metastability circuit. Such a solution provides a random response of the circuit in the case of proximity of the edges of the input waveforms. More specifically, for phase shifts that do not fit in the metastability window, the metastability circuit provides a phase detection and is used to correct the phase of the ring oscillators connected to its inputs. However, for phase shifts located in the metastability window, the metastability circuit provides a random value on its output and consequently induces a random phase change, which differs the this circuit from the phase detector.

### Brief description of the drawings

The invention has been described below in detail, with reference to the attached figures. Fig.1 presents a block diagram of random number generator with two ring oscillators, fig.2 presents a block diagram of random number generator with three ring oscillators, and fig.3 presents a block diagram of metastability circuit comprising metastable generator of time intervals and arbiter circuit.

### Detailed description

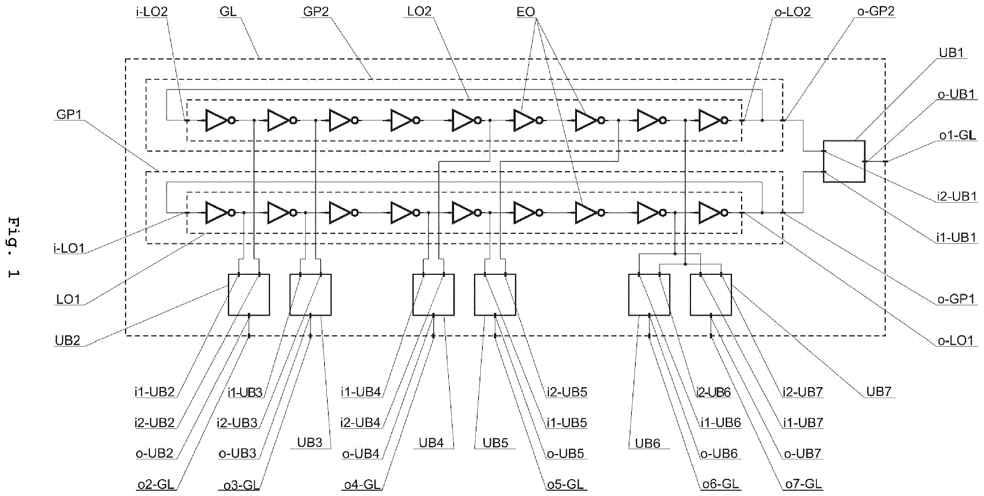

Random number generator presented in fig.1 comprises two ring oscillators GP1 and GP2 and seven bistables UB1, UB2, UB3, UB4, UB5, UB6 and UB7. The ring oscillators GP1 and GP2 comprise delay lines LO1 and LO2 closed in loops so, that an output o-LO1 and o-LO2 of a delay line LO1 and LO2 is connected to an input i-LO1 and i-LO2 of this delay line and also the outputs of the delay lines LO1 and LO2 are connected to outputs of the ring oscillators GP1 and GP2. The delay lines LO1 and LO2 comprise delays EO connected in series between the inputs i-LO1 and i-LO2 and the outputs o-LO1 and o-LO2 of these delay lines. Outputs o-UB1, o-UB2, o-UB3, o-UB4, o-UB5, o-UB6 and o-UB7 of the bistables UB1, UB2, UB3, UB4, UB5, UB6 and UB7 are connected to outputs o1-GL, o2-GL, o3-GL, o4-GL, o5-GL, o6-GL and o7-GL of the random number generator GL. First input i1-UB1 of the first bistable UB1 is connected to the delay line LO1 of the first ring oscillator GP1 to an output of the last delay EO counting from the beginning of this delay line. Second input i2-UB1 of the first bistable UB1 is connected to the delay line LO2 of the second ring oscillator GP2 to an output of the last delay EO counting from the beginning of this delay line. First input i1-UB2 of the second bistable UB2 is connected to the delay line LO1 of the first ring oscillator GP1 to an output of the first delay EO counting from the beginning of this delay line. Second input i2-UB2 of the second bistable UB2 is connected to the delay line LO2 of the second ring oscillator GP2 to an output of the first delay EO counting from the beginning of this delay line. First input i1-UB3 of the third bistable UB3 is connected to the delay line LO1 of the first ring oscillator GP1 to an output of the second delay EO counting from the beginning of this delay line. Second input i2-UB3 of the third bistable UB3 is connected to the delay line LO2 of the second ring oscillator GP2 to an output of the second delay EO counting from the beginning of this delay line. First input i1-UB4 of the fourth bistable UB4 is connected to the delay line LO1 of the first ring oscillator GP1 to an output of the fourth delay EO counting from the beginning of this delay line. Second input i2-UB4 of the fourth bistable UB4 is connected to the delay line LO2 of the second ring oscillator GP2 to an output of the fifth delay EO counting from the beginning of this delay line. First input i1-UB5 of the fifth bistable UB5 is connected to the delay line LO1 of the first ring oscillator GP1 to an output of the fifth delay EO counting from the beginning of this delay line. Second input i2-UB5 of the fifth bistable UB5 is connected to the delay line LO2 of the second ring oscillator GP2 to an output of the seventh delay EO counting from the beginning of this delay line. First input i1-UB6 of the sixth bistable UB6 is connected to the delay line LO1 of the first ring oscillator GP1 to an output of the eighth delay EO counting from the beginning of this delay line. Second input i2-UB6 of the sixth bistable UB6 is connected to the delay line LO2 of the second ring oscillator GP2 to an output of the eighth delay EO counting from the beginning of this delay line. First input i1-UB7 of the seventh bistable UB7 is connected to the delay line LO1 of the first ring oscillator GP1 to an output of the eighth delay EO counting from the beginning of this delay line. Second input i2-UB7 of the seventh bistable UB7 is connected to the delay line LO2 of the second ring oscillator GP2 to an output of the eighth delay EO counting from the beginning of this delay line. The effect of such a construction allows to obtain additional, substantially independent random processes on the outputs o2-GL, o3-GL, o4-GL, o5-GL, o6-GL and o7-GL of the random number generator GL.

The first three of the bistables UB1, UB2 and UB3 are connected to delay lines in the way that assures the delays EO are driven by bistables in the minimal manner and at the same time the bistables are stimulated by similar signals - that is, similar phase shifts of the signals of the ring oscillators GP1 and GP2. The third, the fourth and the fifth of the bistables UB3, UB4 and UB5 are also connected to delay lines in the way that assures the delays EO are driven by bistables in the minimal manner, however each of these bistables is stimulated by completely different phase shift of signals of the ring oscillators GP1 and GP2. The sixth bistable UM6 is stimulated by the same signals as the seventh bistable UM7. The identical structure of these two bistables UM6 and UM7 provides similar conditions for their stimulation, whereas their different structure - in particular symmetrical with respect to one another, but with asymmetrical operating characteristics - ensures the stimulation of these circuits at different phase shifts.

The number of delays and the delay caused by each delay EO determine the basic operating frequencies of the ring oscillators GP1 and GP2. The basic frequency has a random component, resulting from physical phenomena - typical for electronic circuits (noise, thermal phenomena, jitter, etc.) - and because of that the signal phase also manifests random changes.

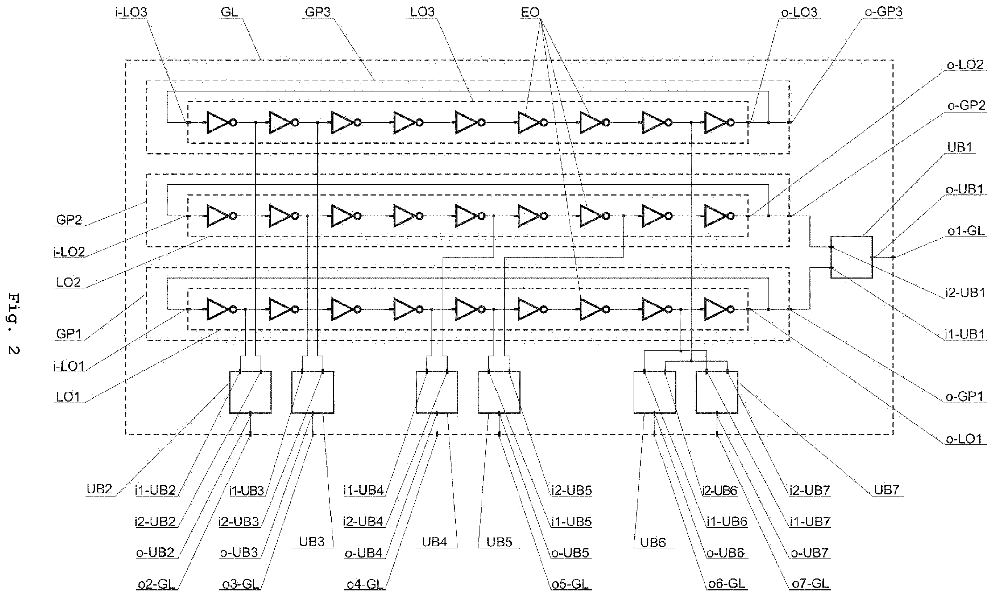

Random number generator presented in fig.2 comprises three ring oscillators GP1, GP2 and GP3 and seven bistables UB1, UB2, UB3, UB4, UB5, UB6 and UB7. The ring oscillators GP1, GP2 and GP3 comprise delay lines LO1, LO2 and LO3 closed in loops so, that an output o-LO1, o-LO2 and o-LO3 of a delay line LO1, LO2 and LO3 is connected to an input i-LO1, i-LO2 and i-LO3 of this delay line and also the outputs of the delay lines o-LO1, o-LO2 and o-LO3 are connected to outputs of the ring oscillators o-GP1, o-GP2 and o-GP3. The delay lines LO1, LO2 and LO3 comprise delays EO connected in series between the inputs i-LO1, i-LO2 and i-LO3 and the outputs o-LO1, o-LO2 and o-LO3 of these delay lines. Outputs o-UB1, o-UB2, o-UB3, o-UB4, o-UB5, o-UB6 and o-UB7 of the bistables UB1, UB2, UB3, UB4, UB5, UB6 and UB7 are connected to outputs o1-GL, o2-GL, o3-GL, o4-GL, o5-GL, o6-GL and o7-GL of the random number generator GL. First input i1-UB1 of the first bistable UB1 is connected to the delay line LO1 of the first ring oscillator GP1 to an output of the last delay EO counting from the beginning of this delay line. Second input i2-UB1 of the first bistable UB1 is connected to the delay line LO2 of the second ring oscillator GP2 to an output of the last delay EO counting from the beginning of this delay line. First input i1-UB2 of the second bistable UB2 is connected to the delay line LO1 of the first ring oscillator GP1 to an output of the first delay EO counting from the beginning of this delay line. Second input i2-UB2 of the second bistable UB2 is connected to the delay line LO3 of the third ring oscillator GP3 to an output of the first delay EO counting from the beginning of this delay line. First input i1-UB3 of the third bistable UB3 is connected to the delay line LO2 of the second ring oscillator GP2 to an output of the second delay EO counting from the beginning of this delay line. Second input i2-UB3 of the third bistable UB3 is connected to the delay line LO3 of the third ring oscillator GP3 to an output of the second delay EO counting from the beginning of this delay line. First input i1-UB4 of the fourth bistable UB4 is connected to the delay line LO1 of the first ring oscillator GP1 to an output of the fourth delay EO counting from the beginning of this delay line. Second input i2-UB4 of the fourth bistable UB4 is connected to the delay line LO2 of the second ring oscillator GP2 to an output of the fifth delay EO counting from the beginning of this delay line. First input i1-UB5 of the fifth bistable UB5 is connected to the delay line LO1 of the first ring oscillator GP1 to an output of the fifth delay EO counting from the beginning of this delay line. Second input i2-UB5 of the fifth bistable UB5 is connected to the delay line LO2 of the second ring oscillator GP2 to an output of the seventh delay EO counting from the beginning of this delay line. First input i1-UB6 of the sixth bistable UB6 is connected to the delay line LO1 of the first ring oscillator GP1 to an output of the eighth delay EO counting from the beginning of this delay line. Second input i2-UB6 of the sixth bistable UB6 is connected to the delay line LO3 of the third ring oscillator GP3 to an output of the eighth delay EO counting from the beginning of this delay line. First input i1-UB7 of the seventh bistable UB7 is connected to the delay line LO1 of the first ring oscillator GP1 to an output of the eighth delay EO counting from the beginning of this delay line. Second input i2-UB7 of the seventh bistable UB7 is connected to the delay line LO3 of the third ring oscillator GP3 to an output of the eighth delay EO counting from the beginning of this delay line. The effect of such a construction allows to obtain additional, substantially independent random processes on the outputs o2-GL, o3-GL, o4-GL, o5-GL, o6-GL and o7-GL of the random number generator GL.

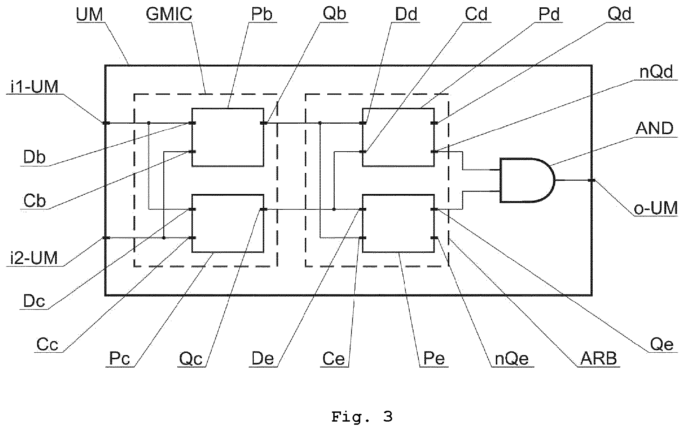

The first three of the bistables UB1, UB2 and UB3 are connected to delay lines in the way that assures the delays EO are driven by bistables in the minimal manner and at the same time the bistables are stimulated by similar signals - that is, similar phase shifts of the signals of the ring oscillators GP1 and GP2, GP1 and GP3, GP2 and GP3. In result the stimulations of bistables connected to different ring oscillators are uncorrelated or slightly correlated, which improves the randomness of numbers on the outputs of these circuits. The first, the fourth and the fifth of the bistables UB1, UB4 and UB5 are also connected to delay lines in the way that assures the delays EO are driven by bistables in the minimal manner, however each of these bistables is stimulated by completely different phase shift of signals of the ring oscillators GP1 and GP2. The sixth bistable UM6 is stimulated by the same signals as the seventh bistable UM7. The identical structure of these two bistables UM6 and UM7 provides similar conditions for their stimulation, whereas their different structure - in particular symmetrical with respect to one another, but with asymmetrical operating characteristics - ensures the stimulation of these circuits at different phase shifts. Metastability circuit presented in fig.3 comprises a metastable generator of time intervals GMIC, an arbiter circuit ARB and a logic circuit AND. The metastable generator of time intervals GMIC comprises two flip-flops Pb and Pc, having two inputs Db and Cb as well as Dc and Cc each, and having single outputs Qb and Qc each. One of the two inputs Db, Cb of the first flip-flop Pb of the metastable generator of time intervals GMIC is a data input Db, the other of the two inputs of the first flip-flop Pb of the metastable generator of time intervals GMIC is a clock input Cb and the single output Qb of the first flip-flop Pb of the metastable generator of time intervals GMIC is a normal output. One of the two inputs Dc, Cc of the second flip-flop Pc of the metastable generator of time intervals GMIC is a data input Dc and the other of the two inputs of the second flip-flop Pc of the metastable generator of time intervals GMIC is a clock input Cc and the single output Qc of the second flip-flop Pc of the metastable generator of time intervals GMIC is a normal output. The arbiter circuit ARB comprises two flip-flops Pd and Pe, having two inputs Dd and Cd as well as De and Ce each, and having two outputs Qd and nQd as well as Qe and nQe each. One of the two inputs Dd, Cd of the first flip-flop Pd of the arbiter circuit ARB is a data input Dd, the other of the two inputs of the first flip-flop Pd of the arbiter circuit ARB is a clock input Cd, one of the two outputs Qd, nQd of the first flip-flop Pd of the arbiter circuit ARB is a normal output Qd and the other of the two outputs is a complementary output nQd. One of the two inputs De, Ce of the second flip-flop Pe of the arbiter circuit ARB is a data input Dd, the other of the two inputs of the second flip-flop Pe of the arbiter circuit ARB is a clock input Ce, one of the two outputs Qe, nQe of the second flip-flop Pe of the arbiter circuit ARB is a normal output Qe and the other of the two outputs is a complementary output nQe. The logic circuit AND consists of a conjunction gate. The logic circuit AND has two inputs and one output. The inputs Db, Cb, Dc, Cc of the flip-flops Pb, Pc of the metastable generator of time intervals GMIC are connected to the inputs i1-UM, i2-UM of the metastability circuit UM so, that the first input i1-UM of the metastability circuit UM is connected to the data input Db of the first flip-flop Pb and the data input Dc of the second flip-flop Pc, whereas the second input i2-UM of the metastability circuit UM is connected to the clock input Cb of the first flip-flop Pb and the clock input Cc of the second flip-flop Pc. The single outputs Qb and Qc of the flip-flops Pb and Pc of the metastable generator of time intervals GMIC are connected to the data inputs Dd, De of the flip-flops Pd, Pe of the arbiter circuit ARB so, that the normal output Qb of the first flip-flop Pb of the metastable generator of time intervals GMIC is connected to the data input Dd of the first flip-flop Pd of the arbiter circuit ARB and the clock input Ce of the second flip-flop Pe of the arbiter circuit ARB, whereas the normal output Qc of the second flip-flop Pc of the metastable generator of time intervals GMIC is connected to the clock input Cd of the first flip-flop Pd of the arbiter circuit ARB and the data input De of the second flip-flop Pe of the arbiter circuit ARB. The output of the metastability circuit o-UM is connected to the selected outputs nQd, Qe of the flip-flops Pd, Pe of the arbiter circuit ARB through the logic circuit AND. The inputs of the logic circuit AND are connected to the complementary output nQd of the first flip-flop Pd of the arbiter circuit ARB and the normal output Qe of the second flip-flop Pe of the arbiter circuit ARB. The output of the logic circuit AND is connected to the output o-UM of the metastability circuit UM.

Providing to the flip-flops Pb and Pc of the metastable generator of time intervals GMIC digital signals with relatively close proximity of the edges of the signals at the inputs of the flip-flops, causes metastable states in them, which result in logical values at the normal outputs Qb and Qc in various moments. Both the logical values and the time intervals are sources of randomness with specific properties of these randomities. The arbiter circuit ARB compares the response times of the flip-flops Pb and Pc, and the result of this comparison - which is a random value - is interpreted by the logic circuit AND as logical zero or logical one.

The invention can be applied and used in generating truly random numbers and series.

## Claims

1. A random number generator (GL) comprising a first bistable (UB1), having an output (o-UB1) connected to a first output (o1-GL) of the random number generator (GL) and comprising two ring oscillators (GP1, GP2), having outputs (o-GP1, o-GP2) connected to inputs (i1-UB1, i2-UB1) of the bistable (UB1), whereas the ring oscillators comprise delay lines (LO1, LO2) closed in a loops, and the delay lines (LO1, LO2) comprise delays (EO) connected in series between inputs (i-LO1, i-LO2) and outputs (o-LO1, o-LO2) of the delay lines (LO1, LO2), wherein the random number generator (GL) comprises at least one additional bistable (UB2, UB3, UB4, UB5, UB6, UB7), having output (o-UB2, o-UB3,o-UB4, o-UB5, o-UB6, o-UB7) connected to an additional output (o2-GL, o3-GL, o4-GL, o-5GL, o6-GL, o7-GL) of the random number generator (GL), whereas the additional bistable (UB2, UB3, UB4, UB5, UB6, UB7) has a first input (i1-UB2, i1-UB3, i1-UB4, i1-UB5, i1-UB6, i1-UB7) connected to the delay line (LO1) of one of the ring oscillators (GP1) and a second input (i2-UB2, i2-UB3, i2-UB4, i2-UB5, i2-UB6, i2-UB7) connected to the delay line (LO2) of the other of the two ring oscillators (GP2), wherein at least one of the bistables (UB) is a metastability circuit (UM), wherein at least one metastability circuit (UM) comprises a metastable generator of time intervals (GMIC), having inputs connected to the inputs of the metastability circuit (il-UM, i2-UM) and outputs connected to inputs of an arbiter circuit (ARB), having outputs connected to the outputs of the metastability circuit (o-UM) through a logic circuit (AND), wherein the metastable generator of time intervals (GMIC) comprises two flip-flops (Pb), (Pc), each having two inputs (Db, Cb), (Dc, Cc) and a single output (Qb), (Qc), wherein one of the two inputs (Db, Cb), (Dc, Cc) is a data input (Db, Dc) and the other of the two inputs (Db, Cb), (Dc, Cc) is a clock input (Cb, Cc) and wherein, the single output (Qb), (Qc) is a normal output, wherein the inputs (Db, Cb), (Dc, Cc) of the flip-flops (Pb), (Pc) of the metastable generator of time intervals (GMIC) are connected to the inputs (il-UM, i2-UM) of the metastability circuit (UM) and wherein the first input (i1-UM) of the metastability circuit (UM) is connected to the data input (Db) of the first flip-flop (Pb) and the data input (Dc) of the second flip-flop (Pc), and the second input (i2-UM) of the metastability circuit (UM) is connected to the clock input (Cb) of the first flip-flop (Pb) and the clock input (Cc) of the second flip-flop (Pc), wherein the arbiter circuit (ARB) comprises two flip-flops (Pd), (Pe) each having two inputs (Dd, Cd), (De, Ce) and two outputs (Qd, nQd), (Qe, nQe), wherein one of the two inputs (Dd, Cd), (De, Ce) is a data input (Dd, De) and the other of the two inputs (Dd, Cd), (De, Ce) is a clock input (Cd, Ce), and wherein one of the two outputs (Qd, nQd), (Qe, nQe) is a normal output (Qd, Qe) and the other of the two outputs is a complementary output (nQd, nQe), and wherein, the normal output (Qb) of the first flip-flop (Pb) of the metastable generator of time intervals (GMIC) is connected to the data input (Dd) of the first flip-flop (Pd) of the arbiter circuit (ARB) and the clock input (Ce) of the second flip-flop (Pe) of the arbiter circuit (ARB), the normal output (Qc) of the second flip-flop (Pc) of the metastable generator of time intervals (GMIC) is connected to the clock input (Cd) of the first flip-flop (Pd) of the arbiter circuit (ARB) and the data input (De) of the second flip-flop (Pe) of the arbiter circuit (ARB), and wherein the logic circuit (AND) consists of a conjunction gate, through which selected outputs (nQd, Qe) of the flip-flops (Pd, Pe) of the arbiter circuit (ARB) are connected to the output (o-UM) of the metastability circuit (UM), wherein the inputs of the logic circuit (AND) are connected to the complementary output (nQd) of the first flip-flop (Pd) of the arbiter circuit (ARB) and the normal output (Qe) of the second flip-flop (Pe) of the arbiter circuit (ARB), wherein at least one of the additional bistables (UB4, UB5) is connected with the first input (i1-UB4, i1-UB5) to a series of delays of a delay line (LO1) of one of the ring oscillators (GP1) after a delay (EO) having the first number in this series counting from the beginning of the delay line (LO1), and the second input (i2-UB4, i2-UB5) is connected to a series of delays of a delay line (LO2) of another ring oscillator (GP2) after a delay (EO) having the second number in this series counting from the beginning of the delay line (LO2), wherein the first number is different from the second number.

2. The random number generator according to claim 1, **characterized in that** it comprises at least one more ring oscillator (GP3), and **in that** the additional bistable (UB2, UB3, UB4, UB5, UB6, UB7), having the output (o-UB2, o-UB3, o-UB4, o-UB5, o-UB6, o-UB7) connected to the additional output (o2-GL, o3-GL, o4-GL, o-5GL, o6-GL, o7-GL) of the random number generator (GL), has the first input (i1-UB2, i1-UB3, i1-UB4, i1-UB5, i1-UB6, i1-UB7) connected to the delay line (LO1, LO2) of one of the ring oscillators (GP1, GP2) and the second input (i2-UB2, i2-UB3, i2-UB4, i2-UB5, i2-UB6, i2-UB7) connected to the delay line (LO2, LO3) of the second or the third of the ring oscillators (GP2, GP3).

3. The random number generator according to claim 2, **characterized in that** it comprises at least two bistables (UB1, UB2, UB3), having at least one of the inputs (i1-UB2, i1-UB3; i2-UB1, i2-UB2; i1-UB1, i2-UB3) connected to different delay lines (LO1, LO2, LO3) of different ring oscillators (GP1, GP2, GP3).

4. The random number generator according to claim 1 or 2 or 3, **characterized in that** at least two bistables (UB6, UB7) are connected with at least one input each (i1-UB6, i1-UB7; i2-UB6, i2-UB7) in the same place of at least one delay line (LO1; LO3).

## Patentansprüche

1. Zufallszahlengenerator (GL) einem ersten bistabilen Element (UB1) umfasst, mit Ausgang (o-UB1) mit einem ersten Ausgang (o1-GL)des Zufallszahlengenerators (GL) verbunden ist, und mit zwei Ringoszillatoren (GP1, GP2), deren Ausgänge (o-GP1, o-GP2) mit den Eingängen (i1-UB1, i2-UB1) des bistabilen Elements (UB1) verbunden sind, wobei die Ringoszillatoren in Schleifen geschlossene Verzögerungsleitungen (LO1, LO2) umfassen und die Verzögerungsleitungen (LO1, LO2) Verzögerungen (LO) umfassen zwischen Eingängen (i-LO1, i-LO2) und Ausgängen (o-LO1, o-LO2) der Verzögerungsleitungen (LO1, LO2) verbunden sind, wobei der Zufallszahlengenerator (GL) umfasst mindestens ein weiteres bistabiles Element (UB2, UB3, UB4, UB5, UB6, UB7) mit Ausgängen (o-UB2, o-UB3, o-UB4, o-UB5, o-UB6, o-UB7), die mit einem zusätzlichen Ausgang (o2-GL, o3-GL, o4-GL, o-5GL, o6-GL, o7-GL) des Zufallszahlengenerators (GL) verbunden sind, wobei die zusätzlichen bistabilen Elemente (UB2, UB3, UB4, UB5, UB6, UB7) einen ersten Eingang (i1-UB2, i1-UB3, i1-UB4, i1-UB5, i1-UB6, i1-UB7) mit der Verzögerungsleitung (LO1) eines der Ringoszillatoren (GP1) verbunden ist und einen zweiten Eingang (i2-UB2, i2-UB3, i2-UB4, i2-UB5, i2-UB6, i2-UB7) mit der Verzögerungsleitung (LO2) eines der Ringoszillatoren (GP2) verbunden ist, wobei mindestens einer der bistabilen Elemente (UB) eine metastabile Schaltung (UM) ist, wobei mindestens eine metastabile Schaltung (UM) einen metastabilen Zeitintervallgenerator (GMIC) umfasst, mit Eingänge mit den Eingängen der metastabilen Schaltung (il-UM, i2-UM) verbunden sind, und Ausgänge aufweist, die mit Eingängen einer Arbiterschaltung (ARB) verbunden sind, die über eine Logikschaltung (AND) mit den Ausgängen der metastabilen Schaltung (o-UM) verbunden ist, wobei der metastabile Zeitintervallgenerator (GMIC) zwei Flipflops (Pb), (Pc) umfasst, die jeweils zwei Eingänge (Db, Cb), (Dc, Cc) und einen einzigen Ausgang (Qb), (Qc) aufweist, wobei einer der beiden Eingänge (Db, Cb), (Dc, Cc) ein Dateneingang (Db, Dc) und der andere der beiden Eingänge (Db, Cb), (Dc, Cc) ein Takteingang (Cb, Cc) ist und wobei der einzige Ausgang (Qb), (Qc) ein normaler Ausgang ist, wobei die Eingänge (Db, Cb), (Dc, Cc) der Flipflops (Pb), (Pc) des metastabilen Zeitintervallgenerators (GMIC) mit den Eingängen (il-UM, i2-UM) der metastabilen Schaltung (UM) verbunden sind und wobei der erste Eingang (i1-UM) der metastabilen Schaltung (UM) mit dem Dateneingang (Db) des ersten Flipflops (Pb) und dem Dateneingang (Dc) des zweiten Flipflops (Pc) verbunden ist, und der zweite Eingang (i2-UM) der metastabilen Schaltung (UM) mit dem Takteingang (Cb) des ersten Flipflops (Pb) und dem Takteingang (Cc) des zweiten Flipflops (Pc) verbunden ist, wobei die Arbiterschaltung (ARB) zwei Flipflops (Pd), (Pe) umfasst, mit jeweils zwei Eingängen (Dd, Cd), (De, Ce) und zwei Ausgängen (Qd, nQd), (Qe, nQe), wobei einer der beiden Eingänge (Dd, Cd), (De, Ce) ein Dateneingang (Dd, De) ist und der andere der beiden Eingänge (Dd, Cd), (De, Ce) ein Takteingang (Cd, Ce) ist, und wobei einer der beiden Ausgänge (Qd, nQd), (Qe, nQe) ein Normalausgang (Qd, Qe) ist und der andere der beiden Ausgänge ein Komplementärausgang (nQd, nQe) ist, und wobei der normale Ausgang (Qb) des ersten Flipflops (Pb) des metastabilen Zeitintervallgenerators (GMIC) mit dem Dateneingang (Dd) des ersten Flipflops (Pd) der Arbiterschaltung (ARB) und dem Takteingang (Ce) des zweiten Flipflops (Pe) der Arbiterschaltung (ARB) verbunden ist, wobei der Normalausgang (Qc) des zweiten Flipflops (Pc) des metastabilen Zeitintervallgenerators (GMIC) mit dem Takteingang (Cd) des ersten Flipflops (Pd) der Arbiterschaltung (ARB) und dem Dateneingang (De) des zweiten Flipflops (Pe) der Arbiterschaltung (ARB) verbunden ist, und wobei die Logikschaltung (AND) aus einem Konjunktionsgatter besteht, über das ausgewählte Ausgänge (nQd, Qe) der Flipflops (Pd, Pe) der Arbiterschaltung (ARB) mit dem Ausgang (o-UM) der metastabilen Schaltung (UM) verbunden sind, wobei die Eingänge der Logikschaltung (AND) mit dem komplementären Ausgang (nQd) des ersten Flipflops (Pd) der Arbiterschaltung (ARB) und dem normalen Ausgang (Qe) des zweiten Flipflops (Pe) der Arbiterschaltung (ARB) verbunden sind, wobei mindestens eines der zusätzlichen bistabilen Elemente (UB4, UB5) mit dem ersten Eingang (i1-UB4, i1-UB5) mit einer Reihe von Verzögerungen einer Verzögerungsleitung (LO1) eines der Ringoszillatoren (GP1) nach einer Verzögerung (EO) verbunden ist, die die erste Nummer in dieser Reihe, gezählt vom Anfang der Verzögerungsleitung (LO1), aufweist, und der zweite Eingang (i2-UB4, i2-UB5) mit einer Reihe von Verzögerungen einer Verzögerungsleitung (LO2) eines anderen Ringoszillators (GP2) verbunden ist, nach einer Verzögerung (EO), die die zweite Nummer in dieser Reihe, gezählt vom Anfang der Verzögerungsleitung (LO2), aufweist, wobei die erste Nummer von der zweiten Nummer verschieden ist.

2. Der Zufallszahlengenerator gemäß Patentansprüche 1, **dadurch gekennzeichnet, dass** er mindestens einen weiteren Ringoszillator (GP3) umfasst und dass der zusätzliche bistabile Schaltkreis (UB2, UB3, UB4, UB5, UB6, UB7) mit dem Ausgang (o-UB2, o-UB3, o-UB4, o-UB5, o-UB6, o-UB7) mit dem zusätzlichen Ausgang (o2-GL, o3-GL, o4-GL, o-5GL, o6-GL, o7-GL) des Zufallszahlengenerators (GL) verbunden ist, mit erster Eingang (i1-UB2, i1-UB3, i1-UB4, i1-UB5, i1-UB6, i1-UB7) mit der Verzögerungsleitung (LO1, LO2) eines der Ringoszillatoren (GP1, GP2) verbunden ist und der zweite Eingang (i2-UB2, i2-UB3, i2-UB4, i2-UB5, i2-UB6, i2-UB7) mit der Verzögerungsleitung (LO2, LO3) des zweiten oder dritten der Ringoszillatoren (GP2, GP3) verbunden ist.

3. Der Zufallszahlengenerator gemäß Patentansprüche 2, **dadurch gekennzeichnet, dass** er mindestens zwei bistabile Elemente (UB1, UB2, UB3) umfasst, die mindestens einen der Eingänge (i1-UB2, i1-UB3;i2-UB1, i2-UB2; i1-UB1, i2-UB3) mit unterschiedlichen Verzögerungsleitungen (LO1, LO2, LO3) unterschiedlicher Ringoszillatoren (GP1, GP2, GP3) verbunden sind.

4. Zufallszahlengenerator gemäß Patentansprüche 1 oder 2 oder 3, **dadurch gekennzeichnet, dass** mindestens zwei bistabile Elemente (UB6, UB7) mit jeweils mindestens einem Eingang (i1-UB6, i1-UB7; i2-UB6, i2-UB7) an derselben Stelle mindestens einer Verzögerungsleitung (LO1; LO3) verbunden sind.

## Revendications

1. Un générateur de nombres aléatoires (GL) comprenant un premier bistable (UB1), ayant une sortie (o-UB1) connectée à une première sortie (o1-GL) du générateur de nombres aléatoires (GL) et comprenant deux oscillateurs en anneau (GP1, GP2), ayant des sorties (o-GP1, o-GP2) connectées à des entrées (i1-UB1, i2-UB1) du bistable (UB1), tandis que les oscillateurs en anneau comprennent des lignes à retard (LO1, LO2) fermées en boucles, et les lignes à retard (LO1, LO2) comprennent des retards (EO) connectés en série entre les entrées (i-LO1, i-LO2) et les sorties (o-LO1, o-LO2) des lignes à retard (LO1, LO2), dans lequel le générateur de nombres aléatoires (GL) comprend au moins un bistable supplémentaire (UB2, UB3, UB4, UB5, UB6, UB7), ayant une sortie (o-UB2, o-UB3, o-UB4, o-UB5, o-UB6, o-UB7) connectée à une sortie supplémentaire (o2-GL, o3-GL, o4-GL, o-5GL, o6-GL, o7-GL) du générateur de nombres aléatoires (GL), tandis que le bistable supplémentaire (UB2, UB3, UB4, UB5, UB6, UB7) a une première entrée (i1-UB2, i1-UB3, i1-UB4, i1-UB5, i1-UB6, i1-UB7) connectée à la ligne en retard (LO1) de l'un des oscillateurs en anneau (GP1) et une deuxième entrée (i2-UB2, i2-UB3, i2-UB4, i2-UB5, i2-UB6, i2-UB7) connectée à la ligne de retard (LO2) de l'autre des deux oscillateurs en anneau (GP2), dans lequel au moins l'un des bistables (UB) est un circuit de métastabilité (UM), dans lequel au moins un circuit de métastabilité (UM) comprend un générateur métastable d'intervalles de temps (GMIC), ayant des entrées connectées aux entrées du circuit de métastabilité (il-UM, i2-UM) et des sorties connectées aux entrées d'un circuit arbitre (ARB), ayant des sorties connectées aux sorties du circuit de métastabilité (o-UM) par l'intermédiaire d'un circuit logique (AND), dans lequel le générateur métastable d'intervalles de temps (GMIC) comprend deux bascules (Pb), (Pc), chacune ayant deux entrées (Db, Cb), (Dc, Cc) et une seule sortie (Qb), (Qc), dans lequel l'une des deux entrées (Db, Cb), (Dc, Cc) est une entrée de données (Db, Dc) et l'autre des deux entrées (Db, Cb), (Dc, Cc) est une entrée d'horloge (Cb, Cc) et dans lequel la seule sortie (Qb), (Qc) est une sortie normale, dans lequel les entrées (Db, Cb), (Dc, Cc) des bascules (Pb), (Pc) du générateur d'intervalles de temps métastable (GMIC) sont connectées aux entrées (il-UM, i2-UM) du circuit de métastabilité (UM) et dans lequel la première entrée(i1-UM) du circuit de métastabilité (UM) est connectée à l'entrée de données (Db) de la première bascule (Pb) et à l'entrée de données (Dc) de la deuxième bascule (Pc), et la deuxième entrée (i2-UM) dedu circuit de métastabilité (UM) est connectée à l'entrée d'horloge (Cb) de la première bascule (Pb) et à l'entrée d'horloge (Cc) de la deuxième bascule (Pc), dans lequel le circuit arbitre (ARB) comprend deux bascules (Pd), (Pe) ayant chacune deux entrées (Dd, Cd), (De, Ce) et deux sorties (Qd, nQd), (Qe, nQe), dans lequel l'une des deux entrées (Dd, Cd), (De, Ce) est une entrée de données (Dd, De) et l'autre des deux entrées (Dd, Cd), (De, Ce) est une entrée d'horloge (Cd, Ce), et dans lequel l'une des deux sorties (Qd, nQd), (Qe, nQe) est une sortie normale (Qd, Qe) et l'autre des deux sorties est une sortie complémentaire (nQd, nQe), et dans lequel la sortie normale (Qb) de la première bascule (Pb) du générateur d'intervalles de temps métastable (GMIC) est connectée à l'entrée de données (Dd) de la première bascule (Pd) du circuit arbitre (ARB) et à l'entrée d'horloge (Ce) de la deuxième bascule (Pe) du circuit arbitre (ARB), la sortie normale (Qc) de la deuxième bascule (Pc) du générateur d'intervalles de temps métastable (GMIC) est connectée à l'entrée d'horloge (Cd) de la première bascule (Pd) du circuit arbitre (ARB) et à l'entrée de données (De) de la deuxième bascule (Pe) du circuit arbitre (ARB), et dans lequel le circuit logique (AND) est constitué d'une porte conjonctive, à travers lesquelles les sorties sélectionnées (nQd, Qe) des bascules (Pd, Pe) du circuit arbitre (ARB) sont connectées à la sortie (o-UM) du circuit de métastabilité (UM), dans lequel les entrées du circuit logique (AND) sont connectées à la sortie complémentaire (nQd) de la première bascule (Pd) du circuit arbitre (ARB) et à la sortie normale (Qe) de la deuxième bascule (Pe) du circuit arbitre (ARB), dans lequel au moins l'un des bistables supplémentaires (UB4, UB5) est connecté à la première entrée (i1-UB4, i1-UB5) à une série de retards d'une ligne à retard (LO1) de l'un des oscillateurs en anneau (GP1) après un retard (EO) ayant le premier nombre dans cette série en comptant à partir du début de la ligne à retard (LO1), et la deuxième entrée (i2-UB4, i2-UB5) est connectée à une série de retards d'une ligne à retard (LO2) d'un autre oscillateur en anneau (GP2) après un retard (EO) ayant le deuxième nombre dans cette série en comptant à partir du début de la ligne à retard (LO2), dans lequel le premier nombre étant différent du deuxième nombre.

2. Le générateur de nombres aléatoires selon la revendication 1, **caractérisé en ce qu'**il comprend au moins un oscillateur en anneau supplémentaire (GP3) et **en ce que** le bistable supplémentaire (UB2, UB3, UB4, UB5, UB6, UB7), ayant la sortie (o-UB2, o-UB3, o-UB4, o-UB5, o-UB6, o-UB7) connectées à la sortie supplémentaire (o2-GL, o3-GL, o4-GL, o-5GL, o6-GL, o7-GL) du générateur de nombres aléatoires (GL), ont la première entrée (i1-UB2, i1-UB3, i1-UB4, i1-UB5, i1-UB6, i1-UB7) connectée à la ligne de retard (LO1, LO2) de l'un des oscillateurs en anneau (GP1, GP2) et la deuxième entrée (i2-UB2, i2-UB3, i2-UB4, i2-UB5, i2-UB6, i2-UB7) connectés à la ligne en retard (LO2, LO3) du deuxième ou du troisième des oscillateurs en anneau (GP2, GP3).

3. Le générateur de nombres aléatoires selon la revendication 2, **caractérisé en ce qu'**il comprend au moins deux bistables (UB1, UB2, UB3), ayant au moins l'une des entrées (i1-UB2, i1-UB3; i2-UB1, i2-UB2; i1-UB1, i2-UB3) connectés à différentes lignes de retard (LO1, LO2, LO3) de différents oscillateurs en anneau (GP1, GP2, GP3).

4. Le générateur de nombres aléatoires selon la revendication 1 ou 2 ou 3, **caractérisé en ce qu'**au moins deux bistables (UB6, UB7) sont connectés avec au moins une entrée chacun (i1-UB6, i1-UB7; i2-UB6, i2-UB7) au même endroit d'au moins une ligne à retard (LO1; LO3).
